# EUROPEAN PATENT SPECIFICATION

(11) **EP 2 123 139 B1**
(45) Date of publication and mention of the grant of the patent: **04.08.2010**
(21) Application number: 07702490.9
(22) Date of filing: 14.02.2007
(51) Int. Cl.: H05K 5/02, H05K 7/20, F03D 11/00

(54) **A SYSTEM FOR RECIRCULATION OF AIR IN A COMPONENT OF A WIND TURBINE**
SYSTEM ZUR REZIRKULATION VON LUFT IN EINER KOMPONENTE EINER WINDTURBINE
SYSTÈME DE RECIRCULATION D'AIR DANS UN COMPOSANT D'ÉOLIENNE

(43) Date of publication of application: 25.11.2009
(73) Proprietor: Vestas Wind Systems A/S, 8940 Randers SV (DK)
(72) Inventor: LARSEN, Gerner, DK-8382 Hinnerup (DK)
(74) Representative: Inspicos A/S
(86) International application number: PCT/DK2007/000072
(87) International publication number: WO 2008/098573

(56) References cited:
- EP-A- 1 586 769
- DE-U1- 20 104 334
- US-A- 4 315 300
- US-B1- 6 438 984
- "NEW COOLING SCHEME FOR ELECTRONIC EQUIPMENT INSTALLED IN AN OPEN, UNSHELTERED EN" IBM TECHNICAL DISCLOSURE BULLETIN, IBM CORP. NEW YORK, US, vol. 39, no. 4, 1 April 1996 (1996-04-01), pages 209-211, XP000587474 ISSN: 0018-8689

## Description

### FIELD OF THE INVENTION

The present invention relates to a system for recirculation of air in a component of a wind turbine. More particularly, the present invention relates to a system for recirculation of air within an at least substantially closed area, such as a nacelle, a cabinet containing electronics, a generator, etc. Furthermore, the invention relates to a system for recirculation of air in which dirt and impurities are at least substantially prevented from entering the recirculated air.

### BACKGROUND OF THE INVENTION

It is sometimes necessary or desirable to provide a flow of recirculated air in a component of a wind turbine, e.g. in order to provide air cooling for various parts or components of the wind turbine, such as heat producing electronics. Components of a wind turbine, such as cabinets comprising electronic equipment, are normally not completely tight, but will normally have holes and/or crevices, e.g. for leading cables etc. to and from the interior of the component. Thereby air from outside the component will be allowed to enter the component. In some air recirculation systems a low pressure may be created inside the component. This is, e.g., the case if the air recirculation system is a cooling system comprising a heat exchanger and a fan pulling air through the heat exchanger; (see e.g. EP 1586769 A2). In this case the heat exchanger functions as a 'flow brake', and the fan therefore creates a low pressure in the region between the heat exchanger and the fan. This low pressure sucks air from outside the component to the interior of the component via the holes and/or crevices. This is often undesirable, because the air being sucked in may comprise dirt or impurities, e.g. in the form of sand or salt, etc., which may be unwanted, or even damaging, inside the component, and it is in particular a problem when the wind turbine is positioned at a site where such impurities are abundant, e.g. in a desert or at an offshore wind farm.

The problems described above may also occur if another kind of 'flow brake' is present in the system; (see e.g. DE 20104334 U1).

### SUMMARY OF THE INVENTION

It is, thus, an object of the invention to provide a system for recirculation of air in a component of a wind turbine, in which it is at least substantially prevented that dirt or impurities enter the system.

According to the present invention the above and other objects are fulfilled by providing a system for recirculation of air in a component of a wind turbine as defined in claim 1.

The system comprises a housing which at least substantially encloses the remaining parts of the system. Thus, the system is an at least substantially closed and/or delimited entity, the housing defining the boundaries of the system. The housing preferably comprises one or more wall parts confining the air being recirculated to the interior of the system. However, the housing is not necessarily hermetically closed, and it may very well comprise holes or crevices, e.g. for allowing cables etc. to be led into and out of the system.

The component may, e.g., be a nacelle, a generator or a part of a generator, electronics, a converter cabinet, etc. This will be described in further detail below.

The fan is arranged on the housing for pulling air from the interior of the housing in such a manner that when the fan is operated, the air of` the system is recirculated. Thus, the fan may advantageously be arranged in a flow path of the system.

The system further comprises an opening, such as a hole, arranged in a wall part of the housing. The opening is arranged in such a manner that air can be drawn from outside the housing to inside the housing via the opening. Thus, the opening should define a fluid passage between the outside and the inside of the housing. Furthermore, the opening should be arranged in such a manner that air is more inclined to enter the system via the opening than via possible holes or crevices of the housing.

The opening has a filter arranged across it. The filter is preferably of a kind which allows air to pass, but prevents passage of dirt and impurities present in the air at the site where the wind turbine is positioned. Such impurities could include sand and/or salt which can both be very damaging to parts positioned at the interior of a wind turbine, such as electronic equipment, generators, etc.

The system further comprises means for drawing air from outside the housing to inside the housing via the opening. Accordingly, said means need to be positioned relatively to the opening in such a manner, that when it is operated, air is drawn via the opening rather than via possible holes or crevices formed in the housing. Thereby it is ensured that when air is drawn from outside the housing to inside the housing, the air passes through the filter, and thereby dirt and impurities are removed from the air, and thus prevented from entering the system. Accordingly, the parts positioned inside the system are protected from such impurities. Furthermore, drawing air to the inside of the housing will cause an overpressure to build up in the interior of the housing. This overpressure will prevent air from outside the housing from entering the housing via possible holes or crevices, thereby even further protecting the parts arranged inside the system. This is very advantageous.

The system further comprises a heat exchanger, and the opening is arranged along a recirculation path for the air in the system, at a position between the heat exchanger and the fan, and the heat exchanger and the fan may form part of the means for drawing air from outside the housing to inside the housing.

Thus, according to the present invention, an overpressure is created inside the system by drawing air into the system in a controlled manner and via a filter, and thereby air containing dirt and/or impurities is prevented from entering the system via holes or crevices in the housing. Accordingly, parts arranged inside the system are protected from dirt and impurities.

According to this embodiment the recirculation system is a cooling system, preferably for providing cooling for electronic components, e.g. arranged in a cabinet also forming the housing. The system circulates air in a flow path which passes the part(s) to be cooled. This passage heats the air, which is then circulated further on through the heat exchanger, where it is cooled before it is recirculated towards the part(s) to be cooled. The opening is arranged along this recirculation path at a position between the heat exchanger and the fan. The fan tends to suck more air than can be delivered through the heat exchanger, i.e. the heat exchanger functions as a 'flow brake'. As a consequence, a low pressure is created in the region between the heat exchanger and the fan. Since the opening is arranged exactly in this region, air will be drawn from outside the housing to inside the housing via the opening, and thereby via the filter, due to the low pressure. As a consequence, an overpressure is created inside the system as such, as described above.

The heat exchanger may be an air to liquid heat exchanger. In this case the recirculated air is cooled by means of a flow of liquid passing through the heat exchanger.

Alternatively, the heat exchanger may be an air to air heat exchanger, in which case the recirculated air is cooled by means of a flow of air passing through the heat exchanger. In this case the system may further comprise means for causing a flow of air to move across the heat exchanger. The air passing through the heat exchanger may advantageously simply be air from outside the housing, and the means for causing a flow of air may simply be or comprise a fan arranged in the vicinity of the heat exchanger.

As an alternative to the heat exchanger, the system may comprise another kind of 'flow brake', e.g. a narrow part of the flow path of the recirculated air. Such a narrow part may, e.g., be obtained by positioning a plate with a hole in it in the flow path, the size of the hole being chosen to match a desired effect of the 'flow brake'. Such an arrangement will have the same effect as the heat exchanger in the sense that a low pressure will be created, thereby drawing air through the opening and the filter. An overpressure will thereby be created in the system as described above.

As another alternative, the system may further comprise an additional fan being arranged at the opening, and the additional fan may form part of the means for drawing air from outside the housing to inside the housing. The additional fan may advantageously be arranged at or near the opening, thereby drawing air directly through the opening and the filter when operated. Accordingly, the air being drawn in this way does not contain dirt or impurities. The air being drawn into the system in this manner further creates an overpressure in the system, and this overpressure prevents air from entering the system via holes or crevices in the housing. Accordingly, air containing dirt or impurities is prevented from entering the system, and the system is thereby protected as described above.

Thus, as described above, the means for drawing air from outside the housing to inside the housing is preferably adapted to cause an overpressure to build up inside the housing.

The system may be or form part of a cooling system for cooling electronics, such as electronic components, of a wind turbine. In this case the system may advantageously be adapted to be arranged in a cabinet containing the electronics, e.g. a converter cabinet. According to this embodiment, the cabinet may advantageously be or form part of the housing of the system. The system may, according to this embodiment, be arranged in such a manner that a flow of recirculated air flows past the electronics to be cooled, i.e. air cooling is provided for the electronics.

Alternatively or additionally, the system may be adapted to recirculate air inside, at or near a generator of a wind turbine. The generator may advantageously be a multipole generator. In order for a multipole generator to function properly, it is very important that dirt and impurities are prevented from getting near the generator. Furthermore, it will in most cases be necessary to provide cooling for a multipole generator, and it is therefore an advantage that such cooling can be provided without introducing dirt or impurities in the vicinity of the generator.

Alternatively or additionally, the system may be adapted to recirculate air inside a nacelle of a wind turbine. In this case the component of the wind turbine is the nacelle, and the walls of the nacelle may advantageously be or form part of the housing. It may, e.g., be desirable to recirculate air in a nacelle in order to provide cooling for various parts of the wind turbine being positioned in the nacelle, e.g. a generator or electronics.

The system may further comprise means for dehumidifying the air being drawn from outside the housing to inside the housing. Various dehumidifying means are known *per se*. It is an advantage to dehumidify the air being drawn into the system, because humid air will normally increase corrosion of various parts of the wind turbine, and therefore dehumidifying the air will slow down corrosion, thereby increasing the expected lifetime of the wind turbine.

The means for dehumidifying air may be arranged at or near the opening. Thereby it can be ensured that the air entering the system is always dehumidified. Alternatively, it may be positioned at any other suitable position.

The means for dehumidifying air may be or comprise a heating element. In this case, the air is dehumidified by heating the air. As an alternative, the means for dehumidifying air may comprise means for recirculating the air without a secondary flow at a heat exchanger. Thereby the recirculated air is heated by the part(s) to be cooled, and this continues until the air has been sufficiently dehumidified.

The system may further comprise means for measuring a pressure inside the housing, and means for alerting an operator in the case that the measured pressure drops below a predefined threshold value.

The measuring means may be any suitable kind of gauge, probe or the like being suitable for measuring a pressure. It is important to maintain the pressure inside the housing above a certain level in order to prevent air from outside the housing from entering the housing via holes or crevices in the housing, i.e. without passing the filter. If it is detected that the pressure inside the housing drops below a predefined threshold level, this is an indication that an insufficient overpressure is present, and that there is therefore a risk that air containing dirt or impurities may enter the housing. A drop in pressure may, e.g., be a sign that the filter needs to be replaced. Alternatively, a door or hatch may be open, thereby preventing creation of a sufficient overpressure, or one or more parts of the system may be failing for some reason. All of the events mentioned above needs attention by the operator, and it is therefore an advantage that an alert is generated.

### BRIEF DESCRIPTION OF THE DRAWINGS

The invention will now be described in further detail with reference to the accompanying drawings in which
Fig. 1 is a perspective view of a system for recirculating air according to an embodiment of the invention,
Fig. 2 is a perspective view of the system of Fig. 1 seen from a different angle,
Fig. 3 is a perspective view with parts broken away of the system of Figs. 1 and 2,
Figs. 4-6 are side views of the system of Figs. 1-3 seen from various angles, and
Fig. 7 is a view from above of the system of Figs. 1-6.

### DETAILED DESCRIPTION OF THE DRAWINGS

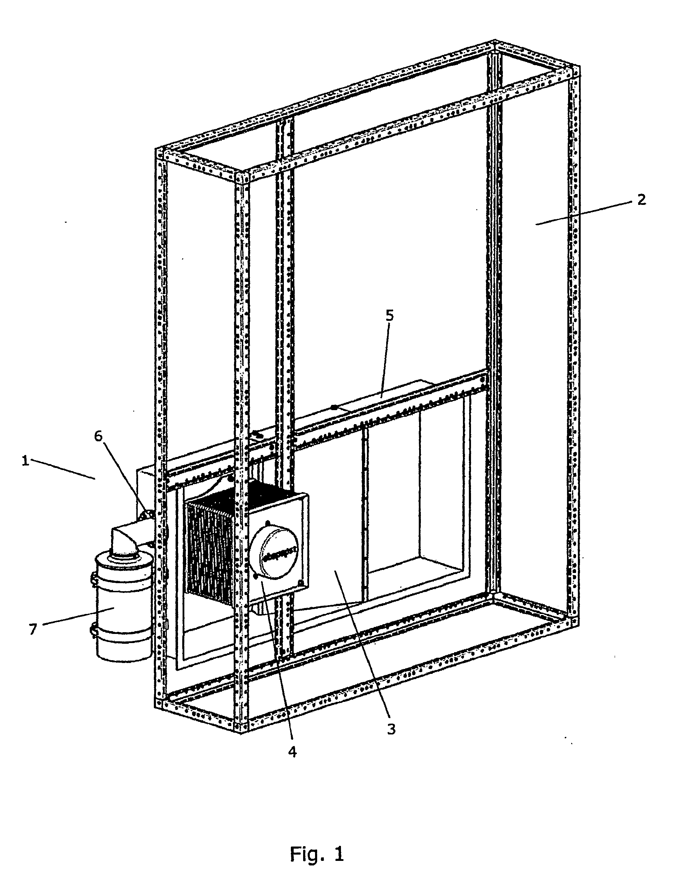

Fig. 1 is a perspective view of a system 1 for recirculating air according to an embodiment of the invention. The system 1 is mounted on a converter cabinet 2. The walls of the converter cabinet 2 have been removed for the sake of clarity. The system 1 comprises a heat exchanger 3 and a fan 4 for recirculating air in the system 1. The fan 4 is arranged in such a manner that it draws air through the heat exchanger 3, further through the fan 4, through the converter cabinet 2 passing components to be cooled (not shown) and back to the heat exchanger 3. The heat exchanger 3 shown in Fig. 1 is an air to liquid heat exchanger, i.e. liquid can pass through the heat exchanger 3 in an up-down direction. However, it should be understood that it may alternatively be an air to air heat exchanger, i.e. of a kind in which a flow of air passes through the heat exchanger 3 in an up-down direction.

The system 1 is enclosed by a housing 5. At a position near the fan 4 an opening 6 is arranged in the housing 5. A filter 7 is arranged across the opening 6, thereby ensuring that any air being drawn from outside the housing 5 to inside the housing 5 passes through the filter 7, thereby preventing dirt or impurities from entering the interior of the housing 5.

The system 1 of Fig. 1 preferably operates in the following manner in order to provide cooling for a number of electronic components arranged inside the converter cabinet 2. The fan 4 is operated, thereby causing air to recirculate inside the system 1 as described above. The heat exchanger 3 functions as a 'flow brake', and therefore a low pressure occurs in the region between the heat exchanger 3 and the fan 4. Due to the low pressure, air is drawn into the system 1 via the opening 6 and the filter 7, i.e. the air being drawn into the system is filtered, and no undesired dirt or impurities will therefore enter the system 1.

The air being drawn into the system 1 as described above causes an overpressure to build up inside the housing 5, and this overpressure prevents air from outside the housing 5 from entering the system 1 via holes or crevices formed elsewhere in the housing 5. Accordingly, air is being drawn into the system 1 in a controlled manner and via the filter 7, and thereby dirt or impurities are prevented from entering the system 1 via holes or crevices, due to the created overpressure.

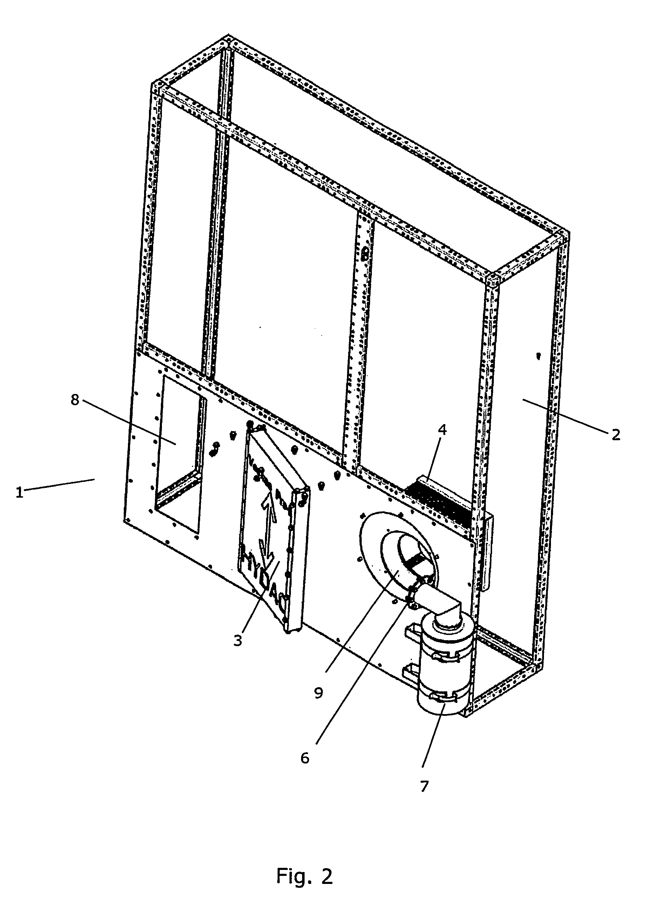

Fig. 2 is a perspective view of the system 1 shown in Fig. 1. The system 1 is shown from a reverse angle as compared to Fig. 1. For the sake of clarity the housing has been removed. From Fig. 2 it is clear that the recirculated air passes from the interior of the converter cabinet 2 through a first opening 8 into the housing, through the heat exchanger 3, and through the fan 4 via a second opening 9. The air is then circulated inside the converter cabinet 2, past the electronic components to be cooled and back to the first opening 8.

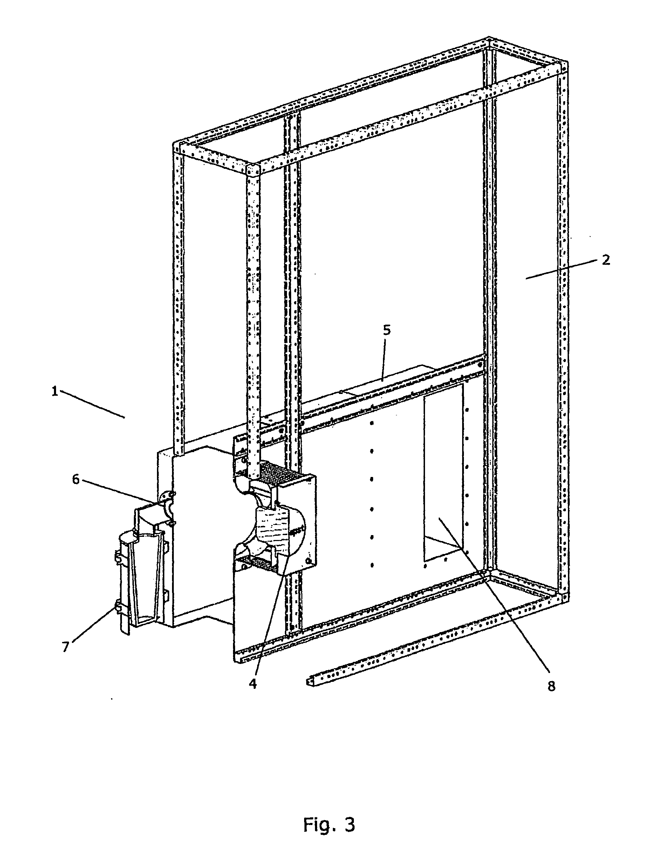

Fig. 3 is a perspective view of the system 1 of Figs. 1 and 2 with parts broken away for the sake of clarity. In Fig. 3 it is possible to see the interior of the fan 4 and of the filter 7. Furthermore, the opening 6 is clearly shown. It is clear from Fig. 3 that the filter 7 is a cone-type filter. It is also clear that the fan 4 is a radial fan. As an alternative, an axial fan could be used. However, it is preferred to use a radial fan, since these tend to provide a larger pressure than axial fans, and the noise level is normally lower.

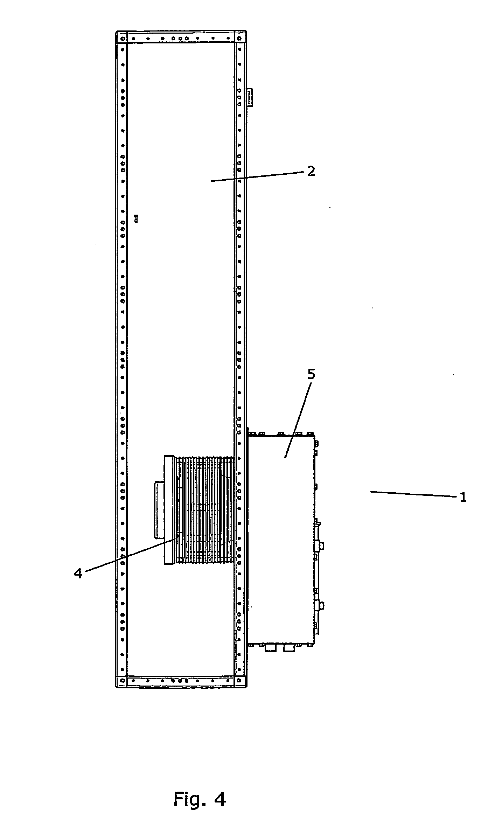

Fig. 4 is a side view of the system 1 of Figs. 1-3. It can be seen from Fig. 4 that the housing 5 is arranged outside the converter cabinet 2 with the fan 4 inside the converter cabinet 2. In Fig. 4 the system 1 is seen in a direction from the end arranged opposite the position of the opening and the filter.

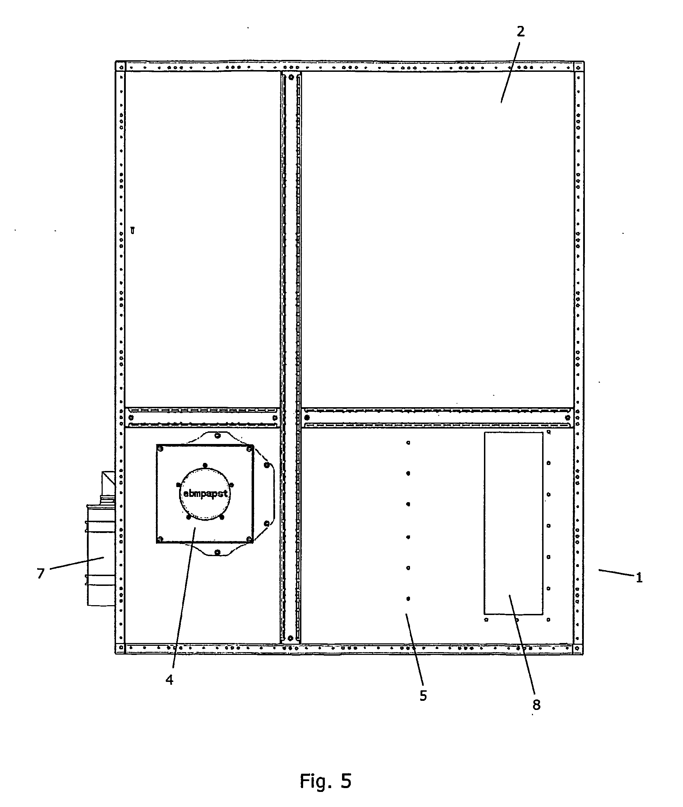

Fig. 5 is a side view of the system 1 of Figs. 1-4, and seen in a transverse direction through the converter cabinet 2. In Fig. 5 the filter 7, the fan 4 and the first opening 8 are visible.

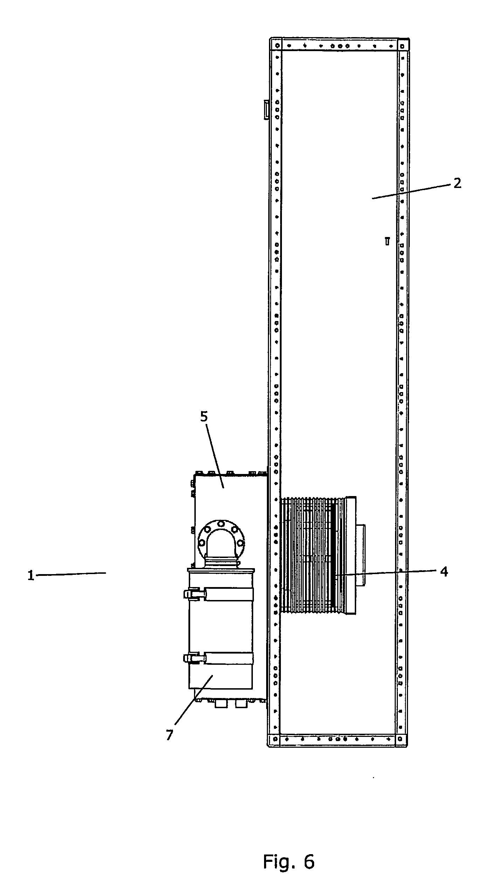

Fig. 6 is a side view of the system 1 of Figs. 1-5, and seen from a direction being opposite to the direction of Fig. 4. Thus, in Fig. 6 the filter 7 and the fan 4 are visible.

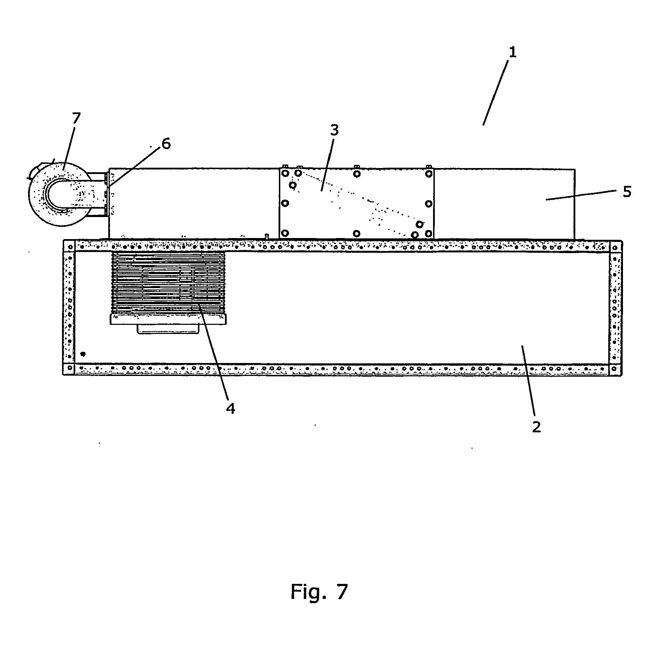

Fig. 7 is a view from above of the system 1 of Figs. 1-6. In Fig. 7 the fan 4, the filter 7, the heat exchanger 3 and the housing 5 are visible.

## Claims

1. A system (1) for recirculation of air in a component of a wind turbine, the system (1) comprising:
- a housing (5) at least substantially enclosing the remaining parts of the system (1),
- a fan (4) arranged on the housing (5) for pulling air from the interior of the housing (5) for causing recirculation of air in the system(1),
- an opening (6) arranged in a wall part of the housing (5) in such a manner that air can be drawn from outside the housing (5) to inside the housing (5) via the opening (6), the opening (6) having a filter (7) arranged across it,
- means for drawing air from outside the housing (5) to inside the housing (5), via the opening (6) and through the filter (7), and
- a heat exchanger (3),
wherein the opening (6) is arrange along a recirculation path for the air in the system (1), at a position between the heat exchanger (3) and the fan (4), and wherein the heat exchanger (3) and the fan (4) form part of the means for drawing air from outside the housing (5) to inside the housing (5).

2. A system (1) according to claim 1, wherein the heat exchanger (3) is an air to liquid heat exchanger.

3. A system (1) according to claim 1, wherein the heat exchanger (3) is an air to air heat exchanger.

4. A system (1) according to claim 3, further comprising means for causing a flow of air to move across the heat exchanger (3).

5. A system (1) according to claim 1, further comprising an additional fan being arranged at the opening (6), said additional fan forming part of the means for drawing air from outside the housing (5) to inside the housing (5).

6. A system (1) according to any of the preceding claims, wherein the means for drawing air from outside the housing (5) to inside the housing (5) is adapted to cause an overpressure to build up inside the housing (5).

7. A system (1) according to any of the preceding claims, wherein the system (1) is or forms part of a cooling system for cooling electronics of a wind turbine.

8. A system (1) according to claim 7, wherein the system (1) is adapted to be arranged in a converter cabinet (2) of a wind turbine.

9. A system (1) according to any of the preceding claims, wherein the system (1) is adapted to recirculate air inside, at or near a generator of a wind turbine.

10. A system (1) according to any of the preceding claims, wherein the system (1) is adapted to recirculate air inside a nacelle of a wind turbine.

11. A system (1) according to any of the preceding claims, further comprising means for dehumidifying the air being drawn from outside the housing (5) to inside the housing (5).

12. A system (1) according to claim 11, wherein the means for dehumidifying air is arranged at or near the opening (6).

13. A system (1) according to claim 11 or 12, wherein the means for dehumidifying air is or comprises a heating element.

14. A system (1) according to any of the preceding claims, further comprising means for measuring a pressure inside the housing (5), and means for alerting an operator in the case that the measured pressure drops below a predefined threshold value.

## Patentansprüche

1. System (1) zum Rückführen von Luft in einem Bauteil einer Windturbine, wobei das System (1)
- ein Gehäuse (5), das wenigstens im Wesentlichen die verbleibenden Teile des Systems (1) umschließt,
- ein an dem Gehäuse (5) angeordnetes Schaufelrad (4) zum Abziehen von Luft aus dem Inneren des Gehäuses (5), um ein Rückführen von Luft in dem System (1) zu bewirken,
- eine Öffnung (6), die derart in einem Wandteil des Gehäuses (5) angeordnet ist, dass Luft von außerhalb des Gehäuses (5) durch die Öffnung (6) in das Gehäuse (5) gesaugt werden kann, wobei die Öffnung (6) einen sie überspannenden Filter (7) aufweist,
- ein Mittel zum Ansaugen von Luft von außerhalb des Gehäuses (5) durch die Öffnung (6) und durch den Filter (7) in das Gehäuse (5) und
- einen Wärmeaustauscher (3) aufweist,
wobei die Öffnung (6) entlang eines Rückführwegs für die Luft in dem System (1) in einem Bereich zwischen dem Wärmeaustauscher (3) sowie dem Schaufelrad (4) angeordnet ist und wobei der Wärmeaustauscher (3) sowie das Schaufelrad (4) einen Teil des Mittels zum Ansaugen von Luft von außerhalb des Gehäuses (5) in das Gehäuse (5) bilden.

2. System (1) nach Anspruch 1, bei dem der Wärmeaustauscher (3) ein Luft/Flüssigkeits-Wärmeaustauscher ist.

3. System (1) nach Anspruch 1, bei dem der Wärmeaustauscher (3) ein Luft/Luft-Wärmeaustauscher ist.

4. System (1) nach Anspruch 3, das weiterhin ein Mittel zum Bewirken einer Luftströmung aufweist, die sich über den Wärmeaustauscher (3) bewegt.

5. System (1) nach Anspruch 1, das weiterhin ein zusätzliches, an der Öffnung (6) angeordnetes Schaufelrad aufweist, wobei das zusätzliche Schaufelrad einen Teil des Mittels zum Ansaugen von Luft von außerhalb des Gehäuses (5) in das Gehäuse (5) bildet.

6. System (1) nach einem der vorangehenden Ansprüche, bei dem das Mittel zum Ansaugen von Luft von außerhalb des Gehäuses (5) in das Gehäuse (5) dazu eingerichtet ist, den Aufbau eines Überdrucks in dem Gehäuse (5) zu bewirken.

7. System (1) nach einem der vorangehenden Ansprüche, bei dem das System (1) ein Kühlsystem zum Kühlen der Elektronik einer Windturbine ist oder einen Teil davon bildet.

8. System (1) nach Anspruch 7, bei dem das System (1) dazu eingerichtet ist, in einem Stromrichterschrank (2) einer Windturbine angeordnet zu werden.

9. System (1) nach einem der vorangehenden Ansprüche, bei dem das System (1) dazu eingerichtet ist, Luft in, an oder bei einem Generator einer Windturbine rückzuführen.

10. System (1) nach einem der vorangehenden Ansprüche, bei dem das System (1) dazu eingerichtet ist, Luft in einer Gondel einer Windturbine rückzuführen.

11. System (1) nach einem der vorangehenden Ansprüche, das weiterhin ein Mittel zum Entfeuchten der von außerhalb des Gehäuses (5) in das Gehäuse (5) angesaugten Luft aufweist.

12. System (1) nach Anspruch 11, bei dem das Mittel zum Entfeuchten von Luft an oder bei der Öffnung (6) angeordnet ist.

13. System (1) nach Anspruch 11 oder 12, bei dem das Mittel zum Entfeuchten von Luft ein Heizelement ist oder über ein solches verfügt.

14. System (1) nach einem der vorangehenden Ansprüche, das weiterhin ein Mittel zum Messen eines Drucks in dem Gehäuse (5) und ein Mittel zum Alarmieren eines Bedieners aufweist, falls der gemessene Druck unter einen vorbestimmten Schwellenwert sinkt.

## Revendications

1. Un système (1) de recirculation d'air dans un composant d'éolienne, le système (1) comprenant :
- un logement (5) comportant au moins substantiellement les parties restantes du système (1),
- un ventilateur (4) placé sur le logement (5) pour aspirer l'air de l'intérieur du logement (5) et permettre la recirculation de l'air dans le système (1),
- une ouverture (6) placée dans une paroi du logement (5) de manière à diriger l'air de l'extérieur du logement (5) vers l'intérieur du logement (5) par l'ouverture (6), l'ouverture (6) disposant d'un filtre (7) la recouvrant,
- des moyens pour diriger l'air de l'extérieur du logement (5) vers l'intérieur du logement (5) par l'ouverture (6) et au travers du filtre (7), et
- un échangeur de chaleur (3),
dans lequel l'ouverture (6) est placée le long d'un chemin de recirculation de l'air dans le système (1), à une position entre l'échangeur de chaleur (3) et le ventilateur (4), et dans lequel l'échangeur de chaleur (3) et le ventilateur (4) forment une partie des moyens pour diriger l'air de l'extérieur du logement (5) vers l'intérieur du logement (5).

2. Un système (1) selon la revendication 1, dans lequel l'échangeur de chaleur (3) est un échangeur de chaleur de type air vers liquide.

3. Un système (1) selon la revendication 1, dans lequel l'échangeur de chaleur (3) est un échangeur de chaleur de type air vers air.

4. Un système (1) selon la revendication 3, comprenant de plus des moyens pour créer un déplacement d'un flux d'air au travers de l'échangeur de chaleur (3).

5. Un système (1) selon la revendication 1, comprenant de plus un ventilateur additionnel placé sur l'ouverture (6), ledit ventilateur additionnel faisant partie des moyens pour diriger l'air de l'extérieur du logement (5) vers l'intérieur du logement (5).

6. Un système (1) selon l'une des revendications précédentes, dans lequel les moyens pour diriger l'air de l'extérieur du logement (5) vers l'intérieur du logement (5) sont adaptés pour créer une surpression à l'intérieur du logement (5).

7. Un système (1) selon l'une des revendications précédentes, dans lequel le système (1) est ou forme une partie d'un système de refroidissement de l'électronique d'une éolienne.

8. Un système (1) selon la revendication 7, dans lequel le système (1) est adapté pour être placé dans un boîtier de conversion (2) d'une éolienne.

9. Un système (1) selon l'une des revendications précédentes, dans lequel le système (1) est adapté pour faire recirculer l'air à l'intérieur, près ou sur un générateur d'une éolienne.

10. Un système (1) selon l'une des revendications précédentes, dans lequel le système (1) est adapté pour faire recirculer l'air à l'intérieur d'une enceinte d'une éolienne.

11. Un système (1) selon l'une des revendications précédentes, comprenant de plus des moyens pour déshumidifier l'air qui est dirigé de l'extérieur du logement (5) vers l'intérieur du logement (5).

12. Un système (1) selon la revendication 11, dans lequel les moyens de déshumidification de l'air sont arrangés près ou sur l'ouverture (6).

13. Un système (1) selon la revendication 11 ou 12, dans lequel les moyens de déshumidification de l'air sont ou comprennent un corps de chauffe.

14. Un système (1) selon l'une des revendications précédentes, comprenant de plus des moyens pour mesurer une pression à l'intérieur du logement (5), et des moyens pour alerter un opérateur lorsque la pression mesurée tombe au-dessous d'une valeur de seuil prédéfinie.
